Europäisches Patentamt

European Patent Office

Office européen des brevets

(11) Publication number: **0 420 318 A1**

# EUROPEAN PATENT APPLICATION

(21) Application number: **90202431.4**

(51) Int. Cl.⁵: **G03F 1/00**

(22) Date of filing: **13.09.90**

(30) Priority: **29.09.89 IT 2189589**

(43) Date of publication of application:
**03.04.91 Bulletin 91/14**

(84) Designated Contracting States:
**AT BE CH DE DK ES FR GB GR IT LI LU NL SE**

(71) Applicant: **REPROCHIM s.r.l.**
**Viale Toscana, 105**
**I-21052 Busto Arsizio (Varese)(IT)**

(72) Inventor: **Contini, Ubaldo**
**Via delle Rose, 18/13**
**I-20025 Legnano (Milano)(IT)**

(74) Representative: **Marchi, Massimo et al**
**c/o Marchi & Mittler s.r.l. Viale Lombardia 20**
**I-20131 Milano(IT)**

(54) Multilayer material for the preparation of full flat background masks for graphic industry and for the production of printed circuits.

(57) The material comprises (a) a first support layer consisting of a film dimensionally stable at a temperature of from -50 to +60°C, substantially transparent to the actinic radiations having wavelength of from 200 to 400 nanometers and having a very smooth surface, (b) a second layer consisting of a flexible extruded film dimensionally stable at a temperature of from -50 to +60°C and substantially opaque to the actinic radiations having wavelength of from 200 to 400 nanometers and (c) a third thin layer of a plastic adhesive compound spreaded between the first and the second layer.

EP 0 420 318 A1

# MULTILAYER MATERIAL FOR THE PREPARATION OF FULL FLAT BACKGROUND MASKS FOR GRAPHIC INDUSTRY AND FOR THE PRODUCTION OF PRINTED CIRCUITS

The present invention relates to a material suitable for preparing, mechanically, full flat background masks for graphic industry and for the production of printed circuits.

It is known that usually, in the graphic industry and in the production of printed circuits for the electronic industry a material generally called mask is used.

Essentially, said mask consists of a film support, transparent to actinic radiations on which the desired image has been produced or reproduced, in positive or in negative, by means of a layer opaque to actinic radiations. Said mask is then superposed to a known material provided with a light-sensitive layer and the whole is exposed to a beam of the actinic light having wavelength of from 200 to 400 nanometers to obtain a positive plate for offset printing process or a duplicate on an orthochromatic photographic film, depending on the known technique which is used and on the light-sensitve material which is employed. In turn, said orthochromatic photographic film is used directly or, after having made photographic countertypes thereof, indirectly to prepare screen printing frames, offset plates and/or masters for printed circuits.

It also is known that many techniques and materials for preparing said masks do exist. However, in the known methods the layer opaque to actinic radiations is formed (i) by spreading on the support film a solution or a soft paste comprising a polymer and a colouring agent in a organic solvent and (ii) by subsequent evaporation of said organic solvent wherein the use of said organic solvent involve expensive antipollution measures.

For example, FR-A-2 206 866 discloses a multilayer material consisting of five layers arranged in the following order: (i) a plastic support film substantially transparent wherein at least a surface is rough or oxidized, (ii) a first adhesive layer, (iii) a layer of a coloured resin (iv) a second adhesive layer optionally added with the same colouring agent as the previous coloured resin layer, and (v) a detachable layer. In the said multilayer material, the third layer consisting of a coloured resin is formed in situ by spreading a coloured solution of a resin in a mixture of organic solvents and subsequent evaporation of the organic solvents.

EP-A-0 188 292 discloses a lightsafe masking film which comprises (i) a plastic support film, (ii) a pressure sensitive adhesive layer formed thereon, and (iii) a lightsafe peelable layer formed on said adhesive layer from a solution of nitrile rubber, nitrocellulose, a tackiness improver and a lightsafe colouring agent in a mixture of organic solvents.

The aim of the present invention is to provide a material for the production of full flat background masks, also known as line masks, carrying images having high quality and high definition while the step for obtaining the image does not involve dangerous or polluting chemical processes.

The main object of the present invention is that said material has such a structural features that it can be manufactured on a large scale in an easy and economical way and, above all, by using as little as possible chemical processes and/or organic solvents.

This object is achieved by means of a multilayer material characterized in that it comprises (a) a first support layer consisting of a film dimensionally stable at a temperature of from -50 to +60° C, substantially transparent to the actinic radiations having wavelegth of from 200 to 400 nanometers and having very smooth surfaces, (b) a second layer consisting of a flexible extruded film dimensionally stable at a temperature of from -50 to +60° C and substantially opaque to the actinic radiations having wavelength of from 200 to 400 nanometers and (c) a third thin layer of a plastic adhesive compound spreaded between the first and the second layer.

Preferably, the first film forming the support layer has a thickness of from 50 to 250 microns and is made of any known thermoplastic polymeric material affording a film having the above cited properties. Examples of suitable thermoplastic polymers are polyesters, polycarbonates, polytetrafluoroethylenes, polyamides, polyphenylenes, polyacetals, cellulose aliphatic esters, polystyrenes, polyacrylamides, polyurethanes, high and low density polyolefins, and the like.

An example of a preferred material is ethylene glycol polyterephthalate.

Preferably, the film forming the second layer, opaque to actinic radiations, has a thickness of from 10 to 60, most preferably from 30 to 40, microns and is made of a thermoplastic polymer. Examples of suitable thermoplastic polymers are polyethylene, polypropylene, polyvinylacetate, polyvinylcarbonate and other similar polymers (Manuale delle Materie Plastiche, Tecniche Nuove publisher, 2^ ed. 1983, pages 161-353). Although said film may occasionally be per se opaque to the actinic radiations having wavelength within 200 to 400 nanometers, said opacity is preferably obtained by embedding in said thermoplasti polymer a compound or a mixture of compounds absorbing the the actinic radiations having wavelength of from 200 to 400 nanometers. This aim may be achieved with all those pigments that, further to absorbing the actinic radiations having wavelength of from 200 to 400 nanometers, are also suitable for coloring thermoplastic polymers and are stable to light at a temperature of from -60 to +220°C. Obviously, compounds that only partially absorb actinic radiations will be usedd together with other compounds absorbing in that spectrum region, within 200 and 400 nanometers, where the first compound does not absorb.

An example of a preferred material for the second layer is a high density polyethylene incoporating from 5 to 25% by weight of a mixture of pigments C.I. Yellow 17 and C.I. Red 38 such as Remafin (R) GGAE30 and BBAE30, respectively.

Concerning the adhesive compound that forms the third layer, the term "plastic" is used to mean that adherence is mainly obtained by adhesive viscosity and that the second layer may be detached from the first one at any time and quite easily, without undergoing any laceration. Examples of suitable plastic adhesive compounds known in the art are concentrated solutions or dispersions of depolymerized rubber, isobutylene low polymers, vinylethers, acrylic copolymers of rosin acids, cyclopentadiene and phthalic anhydridre polycondensates, partially neutralized rosin acid dimers and trimers and mixtures thereof with dicyclopentadiene policondensates.

An example of preferred plastic adhesive compound is Acronal (R) DS3348 by BASF.

Usually it will be preferred to work in such a way, e.g. by suitably treating that surface of the second layer which is in contact with the plastic adhesive compound, that the plastic adhesive compound adheres more firmly to the second layer film than to the first one. Thus, when removing those areas of the second layer which have been delimited by cutting, the plastic adhesive compound still sticking to them is also removed to therefore leave the uncovered surface of the first layer substantially free from adhesive compound.

The material according to the present invention can be easily produced by means of conventional coupling machines.

The method for manufacturing a mask with a material according to the present invention is very simple. In fact, it merely consists in (a) cutting, manually or by means of a plotter provided with a cutting tool, the second layer (opaque to the actinic radiations) along the desired path and (b) then lifting and removing those areas of said second layer that have been delimited by said cut. Optionally, the adhesive compound residues remaining on the support layer can be removed by means of a cotton wad soaked with a suitable solvent.

Alternatively, in order to avoid that some traces of adhesive plastic compound remain on the support film, this film may be spread with a silicone oil capable of adhering to the adhesive plastic compound before coupling the support film with the coloured layer by means of the adhesive plastic compound when manufacturing the multilayer material according to this invention.

A further object of the invention are therefore the full backgrounds masks for graphic industries or for the production of printed circuits which have been made from a multilayer material according to the present invention.

The following example will disclose the invention in a non limiting way.

Example 1

A pelletized high density polyethylene was admixed with about 8% of a 35:65 (w/w) mixture of pigments C.I. Yellow 17 and C.I. Red 38 and was extruded in 15 microns thick films, 100, 105, 115, or 120 cm wide and long about 2160 m that were progressively winded on suitable chucks.

One of the thus obtained bobbins was loaded on a Rotomec (R) coupling machine on which was loaded also a bobbin, having the same width and length, of a support film made of ethylene glycol polyterephthalate 80 micron thick, while the proper thank of the coupling machine was loaded with a plastic adhesive compound (Acronal (R) DS 3348 by BASF). The coupling machine was then operated.

The plastic adhesive compound was thus spread on the high density polyethylene film at the rate of 2-10 g/m² (dry weight) and, before being coupled to the support film, the high density polyethylene film was passed through the oven of the coupling machine to evaporate the solvent from the plastic adhesive compound. The high density polyethylene film thus treated and the support film, optionally spread with a silicone oil which adheres to said plastic adhesive compound, were fed to the actual coupling device consisting of two rollers pressing together the films. The thus obtained material was winded onto a chuck to give a bobbin ready to be sent to the packaging department.

The material prepared as described above was cut along desired paths by means of a plotter provided with a suitable cutting tool and the areas delimited by said cut were very easily manually removed.

Full flat background masks that gave excellent positive plates for offset printing and excellent masters for printed circuits were thus obtained.

Similar results were obtained by preparing high density polyethylene films having a thickness of 30, 45 and 60 microns and containing 15 or 23% of 50:50 and 65:35 (w/w) mixtures, respectively, of C.I. Yellow 17 and C.I. Red 38 pigments and by coupling them with 150 and 230 microns thick support films by means of plastic adhesive compounds having composition and properties similar to those of Acronal (R) DS 3348 (BASF).

## Claims

1. A multilayer material for preparing full flat background masks for graphic industry and printed circuit production, characterized in that it comprises (a) a first support layer consisting of a film dimensionally stable at a temperature of from -50 and +60° C, substantially transparent to the actinic radiations having wavelength from 200 to 400 nanometers and having very smooth surfaces, (b) a second layer consisting of a flexible extruded film dimensionally stable at a temperature of from -50 to +60° C and substantially opaque to the actinic radiations having wavelength from 200 to 400 nanometers and (c) a third thin layer of a plastic adhesive compound spreaded between the first and the second layer.

2. A multilayer material according to claim 1, characterized in that said first layer has a thickness of from 50 to 250 microns.

3. A multilayer material according to claim 1 or 2, characterized in that said first layer is made of a thermoplastic material selected from the group comprising polyesters, polycarbonates, polytetrafluoroethylenes, polyamides, polyphenylenes, polyacetals, cellulose aliphatic esters, polystyrenes, polyacrylamides and polyurethanes.

4. A mutlilayer material according to claim 3, characterized in that said polimeric thermoplastic material is ethylene glycol polyterephthalate.

5. A multilayer material according to anyone of claims from 1 to 4, characterized in that the thickness of said second layer is of from 10 to 60 microns.

6. A multilayer material according to anyone of claims from 1 to 5, characterized in that said second layer is made of high density polyethylene.

7. A multilayer material according to claim 6, characterized in that in the high density polyethylene there are incorporated the pigments C.I. Yellow 17 and C I. Red 38.

8. A multilayer material according to anyone of claims from 1 to 7, characterized in that said third layer is made of a concentrated solution or dispersion of depolymerized rubber, isobutylene low polymers, vinylethers, acrylic copolymers of rosin acids, cyclopentadiene and phthalic anhydride polycondensates, partially neutralized rosin acid dimers and trimers and mixtures thereof with dicyclopentadiene policondensates.

9. A multilayer material according to claim 8, characterized in that the third layer is made of Acronal (R) DS 3348.

10. Full flat background masks for graphic industry or for printed circuit production prepared from a multilayer material according to one or more of claims from 1 to 9.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y,D | FR-A-2206866 (DAICEL)<br>* page 3, line 4 *<br>* page 3, lines 14 - 15 *<br>* page 5, lines 21 - 28 *<br>* page 6, lines 27 - 28 *<br>* page 7, lines 21 - 24 * | 1-5,<br>8-10 | G03F1/00 |
| Y | DE-A-1934722 (RENKER)<br>* page 5, lines 21 - 32 *<br>* page 10, lines 20 - 29 *<br>* page 11, line 28 - page 12, line 5 * | 1-7 | |
| Y,D | EP-A-0188292 (SOMAR)<br>* page 3, lines 10 - 23 *<br>* page 11, lines 1 - 5 * | 1-5,<br>7-10 | |
| | | | **TECHNICAL FIELDS SEARCHED (Int. Cl.5)**<br><br>G03F |

The present search report has been drawn up for all claims

| Place of search | Date of completion of the search | Examiner |
|---|---|---|
| THE HAGUE | 09 OCTOBER 1990 | MAGRIZOS S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

............................................................................

& : member of the same patent family, corresponding document

EPO FORM 1503 03.82 (P0401)